# EUROPEAN PATENT APPLICATION

(11) **EP 2 369 744 A1**
(43) Date of publication of application: **28.09.2011**
(21) Application number: 11250259.6
(22) Date of filing: 07.03.2011
(51) Int. Cl.: H03K 17/12, H03K 17/082, G05F 1/56, H03K 17/06

(54) **Remote power controller with parallel FETs**

(30) Priority: 26.03.2010 US 732540
(71) Applicant: Hamilton Sundstrand Corporation, Windsor Locks, CT 06096-1010 (US)
(72) Inventor: Fox, David A., Rockford, IL 61109 (US)
(74) Representative: Tomlinson, Kerry John

(57) **Abstract**

A remote power controller (RPC) (100) includes a line connection (112); a load connection (109); a first field effect transistor (FET) (105) and a second FET (104) arranged in parallel between the line connection and the load connection, wherein the first FET has a lower safe operating area (SOA) than a SOA of the second FET, and wherein the first FET has a lower resistance at saturation (RDS(on)) than the second FET; and a voltage offset element (106) connected between the first FET (105) and the second FET (104), such that in the event that a current in the RPC is above a current limiting setpoint, the voltage offset element (106) is configured to cause the first FET (105) to turn off.

## Description

### FIELD OF INVENTION

The subject matter disclosed herein generally to the field of remote power controllers.

### DESCRIPTION OF RELATED ART

A remote power controller (RPC) is a solid state device that controls and protects a power connection to an electrical load. RPCs may be found in complex electrical systems, including but not limited to aircraft or spacecraft electrical systems. RPCs allow switching to be performed at the load, instead of at the power source, reducing the complexity of the overall electrical system. An RPC acts to control the application of power to the load, and may also act as a fuse or circuit breaker, protecting electrical equipment from fault or overload conditions. For DC power applications, an RPC may be designed to limit the current to a prescribed level to protect the power distribution system.

An RPC may comprise a metal oxide semiconductor field effect transistor (MOSFET or FET) having a relatively high power capability and a low voltage drop. The voltage drop across the RPC depends on the resistance of the FET in the ON state, a parameter called RDS(on). Low voltage drop across the RPC is important to reduce losses and increase RPC efficiency. A FET in a current limiting RPC must support the current limiting value while sustaining up to full line voltage when a fault or overload occurs. Therefore, the FET must dissipate a large amount of power during the fault. A relatively high power level may only be sustained by a FET for a limited period of time, depending on the energy capability of the FET. The energy capability of a FET is represented by a plot of voltage vs. current with defined areas for specific time durations. This specifies the safe operating area (SOA) of the FET.

Some FETs, which may be relatively small, are designed for switching applications and can achieve much lower RDS(on) values; however, the smaller FETs may have greatly reduced energy (SOA) capability. A FET having a higher RDS(on) may also be larger, and may have greatly increased SOA capability compared to a smaller FET. A type of FET with large SOA capability that is preferred for operation with both voltage and current applied is a linear FET.

### BRIEF SUMMARY

According to one aspect of the invention, a remote power controller (RPC) includes a line connection; a load connection; a first field effect transistor (FET) and a second FET arranged in parallel between the line connection and the load connection, wherein the first FET has a lower safe operating area (SOA) than a SOA of the second FET, and wherein the first FET has a lower resistance at saturation (RDS(on)) than the second FET; and a voltage offset element connected between the first FET and the second FET, such that in the event a current in the RPC is above a current limiting setpoint, the voltage offset element is configured to cause the first FET to turn off.

According to another aspect of the invention, a method of operating a remote power controller (RPC), the RPC comprising a line connection, a load connection, and a first field effect transistor (FET) and a second FET arranged in parallel between the line connection and the load connection, wherein the first FET has, a lower safe operating area (SOA) than a SOA of the second FET, wherein the first FET has a lower resistance at saturation (RDS(on)) than the second FET, includes in the event that a current in the RPC is below a current limiting setpoint, turning the first FET on, and turning the second FET on; and in the event that a current in the RPC is above the current limiting setpoint, turning the first FET off.

Other aspects, features, and techniques of the invention will become more apparent from the following description taken in conjunction with the drawings.

### BRIEF DESCRIPTION OF THE SEVERAL VIEWS OF THE DRAWINGS

Referring now to the drawings wherein like elements are numbered alike in the several FIGURES:

FIG. 1 illustrates an embodiment of a remote power controller comprising parallel FETs.

FIG. 2 illustrates an embodiment of a method of operating a remote power controller comprising parallel FETs.

FIGs. 3A-B illustrate embodiments of a timing diagrams for a remote power controller comprising parallel FETs.

### DETAILED DESCRIPTION

Embodiments of systems and methods for an RPC with parallel FETs are provided, with exemplary embodiments being discussed below in detail. An RPC may comprise parallel FETs, each FET being of a different type. Use of parallel FETs having different characteristics in an RPC may reduce the load on each individual FET to a sustainable level. One of the FETs may be selected for use during normal operating conditions, and the other may be selected for current limiting or dissipation of overload conditions.

FET characteristics include safe operating area (SOA) and RDS(on). The SOA defines the power and energy handling capability of a FET. The SOA defines a range of drain current values and a range of drain to source voltage values that the FET is able to handle for a certain time without damage. Both the drain current and the drain to source voltage in operation must stay below their respective maximum values for safe operation of the FET, and the product of the drain current and the voltage must also stay below the maximum power dissipation for the FET device. RDS(on) gives the resistance of the FET when the FET is fully turned on (i.e., when the FET is at saturation).

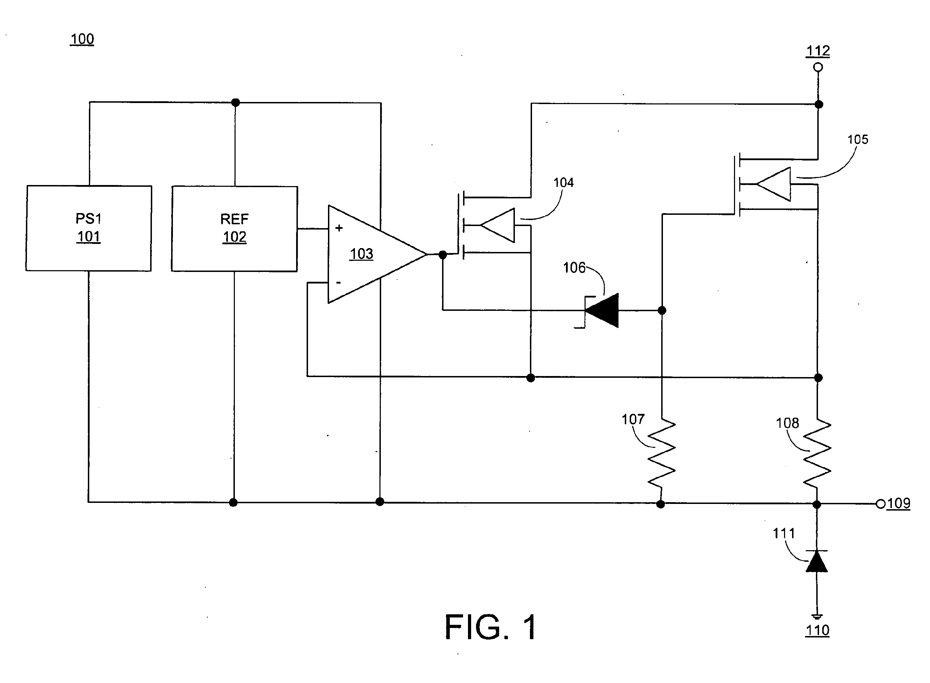

Figure 1 shows an embodiment of a RPC 100 comprising parallel FETs 104 and 105. The function of the RPC 100 is to control and protect the wire and load connected to load connection 109, which is powered by the power source connected to line connection 112. FET 105 may have a relatively low RDS(on) and reduced SOA capability. FET 104 may comprise a linear FET, having a higher SOA capability and relatively high RDS(on). Current flows through RPC 100 from line connection 112 through FETs 104 and/or 105 to load connection 109. Voltage offset element 106 is located between the gate voltage of FET 104 and the gate voltage of FET 105. RPC 100 further comprises a power supply 101, reference voltage 102, a differential amplifier 103, resistors 107 and 108, load connection 109, ground connection 110, commutating diode 111, and line connection 112. Power supply 101 may comprise a gate drive power supply for FETs 104 and 105. Power supply 101 may be a 10 to 15 volt power supply in some embodiments. Reference voltage 102 may be in the range of millivolts in some embodiments. The voltage across voltage offset element 106 may be on the order of a few volts. Voltage offset element 106 may comprise a voltage divider, a battery, or one or more diodes, such as a zener diode in some embodiments. The value of resistor 107 may be in the thousands of ohms in some embodiments, and the value of resistor 108 may be in the range of milliohms in some embodiments. Resistor 108 comprises a shunt, and provides a low millivolt signal to differential amplifier 103. RPC 100 may further comprise gain and frequency response shaping elements around differential amplifier 103, rise and fall time controls, or a timing circuit to control the current limiting time in some embodiments.

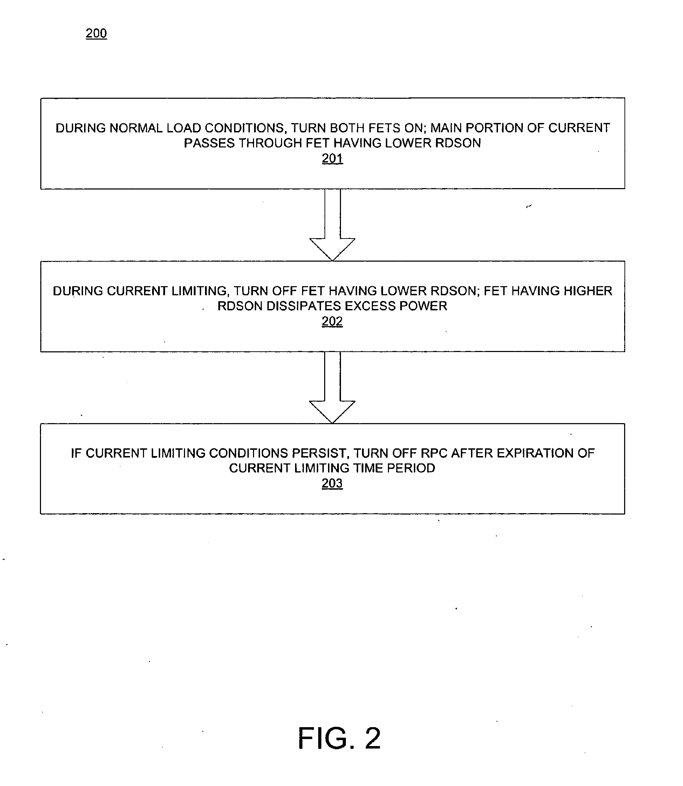

FIG. 2 illustrates an embodiment of a method 200 of operating an RPC comprising parallel FETs. FIG. 2 is discussed with reference to FIG. 1. In block 201, the RPC 100 operates at a normal load. The current in RPC 100 is below a current limiting setpoint during normal load. The current limiting setpoint is determined by the power capability of the load connected to load connection 109. The output of differential amplifier 103 is high, and sufficient gate voltage is applied to both FETs 104 and 105 to turn them both on. However, more current passes through FET 105 than through FET 104, because FET 105 has a RDS(on) that is lower than the RDS(on) of FET 104. In block 202, the RPC 100 operates in current limiting mode, which may comprise an overload or fault condition. Current limiting mode is triggered when the current in RPC 100 is higher than the current limiting setpoint. Differential amplifier 103 compares the shunt voltage from resistor 108 to reference voltage 102, and adjusts the gate drive to FET 104 to a medium voltage to maintain the current at the desired current limiting level. The reduced voltage across voltage offset element 106 and resistor 107 causes FET 105 to turn off, so that the current in the RPC 100 passes only through FET 104. Because of the higher SOA of FET 104, FET 104 may dissipate power over a relatively wide range of current and voltage values. If current limiting conditions persist, in block 203, RPC 100 turns off after expiration of a current limiting time period. The current limiting time period may be determined based on the SOA of FET 104, and may be a fixed time period, or may be an amount of time inversely proportional to the voltage across the RPC 100. The current limiting time period may be enforced by a timing circuit in some embodiments.

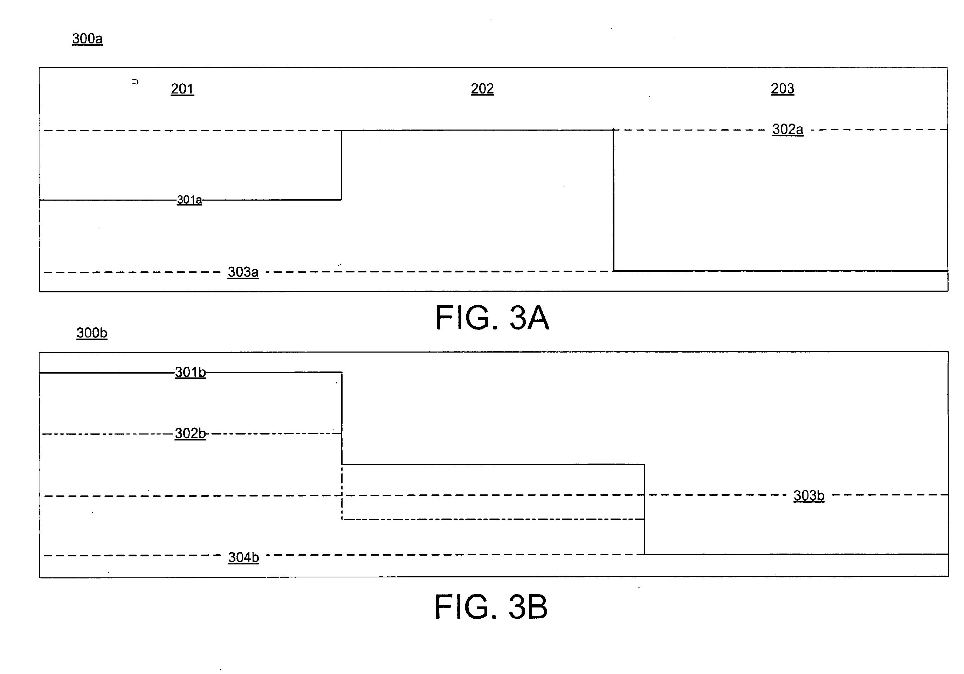

FIGs. 3A-B illustrate embodiments of timing diagrams for an RPC comprising parallel FETs. FIGs. 3A-B are discussed with reference to FIG. 2. In FIG. 3A, line 301a represents the current levels in the RPC 100. During normal operation (block 201 of FIG. 2), the current 301a is between zero (represented by line 303a) and the current limiting setpoint (represented by line 302a). During current limiting (block 202 of FIG. 2), current 301 a is limited to the current limiting setpoint 302a. After expiration of the current limiting time period (block 203 of FIG. 2), the RPC 100 switches off, and the current 301a goes to zero line 303a. In FIG. 3B, line 301b represents the gate voltage of FET 105, and line 302b represents the gate voltage of FET 104. Line 303b represents a FET gate threshold (i.e., the amount of voltage required to turn on a FET) and line 304b represents a voltage of zero. During normal operation (block 201 of FIG. 2), the gate voltages 301b and 302b are both above the FET gate threshold 303b. During current limiting (block 202 of FIG. 2), gate voltage 301b is above the FET gate threshold 303b, and gate voltage 302b is below the FET gate threshold 303b. After expiration of the current limiting time period (block 203 of FIG. 2), the RPC 100 switches off, and both gate voltages 301b and 302b go to zero line 304b.

The technical effects and benefits of exemplary embodiments include protection of electrical equipment from overload or fault conditions.

The terminology used herein is for the purpose of describing particular embodiments only and is not intended to be limiting of the invention. While the description of the present invention has been presented for purposes of illustration and description, it is not intended to be exhaustive or limited to the invention in the form disclosed. Many modifications, variations, alterations, substitutions, or equivalent arrangement not hereto described will be apparent to those of ordinary skill in the art. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. A remote power controller (RPC) (100), comprising:
a line connection (112);
a load connection (109);
a first field effect transistor (FET) (105) and a second FET (104) arranged in parallel between the line connection (112) and the load connection (109), wherein the first FET (105) has a lower safe operating area (SOA) than a SOA of the second FET (104), and wherein the first FET (105) has a lower resistance at saturation (RDS(on)) than the second FET (104); and
a voltage offset element (106) connected between the first FET (105) and the second FET (104), such that in the event that a current in the RPC is above a current limit setpoint, the voltage offset element (106) is configured to cause the first FET (105) to turn off.

2. The RPC (106) of claim 1, wherein the voltage offset element (106) comprises one of a voltage divider, a battery, or a diode.

3. The RPC (100) of claim 1, wherein the voltage offset element (106) comprises a zener diode.

4. The RPC (100) of claim 1, 2 or 3, further comprising a differential amplifier (103) having an output, the output of the differential amplifier (103) being connected to a gate of the first FET (105) and to a gate of the second FET (104).

5. The RPC (100) of claim 4, wherein the voltage offset element (106) is located in between the first FET (105) and the output of the differential amplifier (103).

6. The RPC (100) of claim 4 or 5, wherein a first input of the differential amplifier (103) is connected to a reference voltage (102), and a second input of the differential amplifier (103) is connected to a shunt (108).

7. The RPC (100) of any preceding claim, further comprising a timing circuit configured to turn off the RPC (100) after elapsing of a current limiting time period after the first FET (105) is turned off.

8. The RPC (100) of claim 7, wherein the current limiting time period is a predetermined time period.

9. The RPC (100) of claim 7, wherein the current limiting time period is inversely proportional to a voltage across the RPC (100).

10. The RPC (100) of claim 7, wherein the current limiting time period is based on the SOA of the second FET (104).

11. A method of operating a remote power controller (RPC) (100), the RPC (100) comprising a line connection (112), a load connection (109), and a first field effect transistor (FET) (105) and a second FET (104) arranged in parallel between the line connection (112) and the load connection (109), the method comprising:
in the event that a current in the RPC (100) is below a current limiting setpoint, turning the first FET (105) on, and turning the second FET (104) on, wherein the first FET (105) has a lower safe operating area (SOA) than a SOA of the second FET (104), wherein the first FET (105) has a lower resistance at saturation (RDS(on)) than the second FET (104); and
in the event that a current in the RPC (100) is above the current limiting setpoint, turning the first FET (105) off.

12. The method of claim 11, wherein turning the first FET (105) off comprises providing a voltage offset (106) between the first FET (105) and the second FET (104), wherein the voltage offset (106) is configured to cause the first FET (105) to turn off.

13. The method of claim 11 or 12, further comprising turning off the RPC (100) after elapsing of a current limiting time period after the first FET (105) is turned off.

14. The method of claim 13, wherein the current limiting time period is inversely proportional to a voltage across the RPC (100).

15. The method of claim 13, wherein the current limiting time period is based on the SOA of the second FET (104).
